# EUROPÄISCHE PATENTSCHRIFT

(11) **EP 2 024 069 B1**
(45) Veröffentlichungstag und Bekanntmachung des Hinweises auf die Patenterteilung: **03.02.2010**
(21) Anmeldenummer: 07725640.2
(22) Anmeldetag: 29.05.2007
(51) Int. Cl.: B01D 69/02, B01D 71/02, B01D 67/00, G03F 1/14

(54) **HERSTELLUNG VON MIKRO- UND NANOPOREN-MASSENANORDNUNGEN DURCH SELBSTORGANISATION VON NANOPARTIKELN UND SUBLIMATIONSTECHNIK**
PRODUCTION OF MICRO- AND NANOPORE MASS ARRANGEMENTS BY SELF-ORGANIZATION OF NANOPARTICLES AND SUBLIMATION TECHNOLOGY
PRODUCTION D'ENSEMBLES DE MASSES À MICROPORES ET NANOPORES GRÂCE À UNE AUTO-ORGANISATION DE NANOPARTICULES ET UNE TECHNOLOGIE DE SUBLIMATION

(30) Priorität: 30.05.2006 DE 102006025121
(43) Veröffentlichungstag der Anmeldung: 18.02.2009
(73) Patentinhaber: MPG Max-Planck-Gesellschaft zur Förderung der Wissenschaften e.V., 80539 München (DE)
(72) Erfinder: SPATZ, Joachim, 89520 Heidenheim (DE); LOHMÜLLER, Theobald, 90473 Nürnberg (DE)
(74) Vertreter: Katzameyer, Michael
(86) Internationale Anmeldenummer: PCT/EP2007/004749
(87) Internationale Veröffentlichungsnummer: WO 2007/137821

(56) Entgegenhaltungen:
- EP-A2- 0 083 510
- WO-A-2004/010229
- US-A- 5 871 870
- US-A1- 2002 179 565
- US-A1- 2003 150 791

## Beschreibung

Die vorliegende Erfindung betrifft ein neuartiges Verfahren zur Herstellung von großflächigen Mikro- und Nanoporen-Massenanordnungen durch reine Selbstorganisation. Die Porenanordnung kann auf der Substratoberfläche in diskreten Bereichen kontrolliert werden. Die Größe der Poren und der laterale Porenabstand sind im Mikro- und Nanometermaßstab einstellbar.

Mikro- und Nanoporen bzw. Porenanordnungen finden zahlreiche Anwendungen, beispielsweise als biomimetische Modellsysteme zur Simulation und Aufklärung von auf zellulärer Membranebene ablaufenden Prozessen. Der intra- und interzelluläre Ionen- und Molekültransport und die Aufrechterhaltung des elektrischen Potentials zwischen Zellen und ihrer Umgebung werden durch Nanoporensysteme reguliert. So ist beispielsweise der Zellkern eukaryontischer Lebewesen durch eine mit Poren durchsetzte Kernhülle von der übrigen Zelle abgegrenzt. Der wechselseitige Transport von RNA, Proteinen und Molekülen zwischen Kern und Cytoplasma durch diese Membranöffnungen ist von entscheidender Bedeutung für zellregulative Vorgänge wie Wachstum und Zellteilung. [M. Beck, F. Förster, M. Ecke, J. M. Plitzko, F. Melchior, G. Gerisch, W. Baumeister, O.Medalia, Science, Bd. 306, Issue 5700, 1387-1390, 19. November 2004] Weiterhin werden Anwendungen als elektronische Bauelemente, in der Biosensorik sowie im analytischdiagnostischen Bereich, als Wirkstoffdepots und zur Wirkstoffauslieferung untersucht [T. A. Desai *et al*., "Nanopore Technology for Biomedical Applications"].

In Kombination mit technisch etablierten optischen Lithographieverfahren können derartige Strukturen als Maske zur Darstellung weiterer nanoskaliger Materialien verwendet werden [S. A. Knaack, J. Eddington, Q. Leonard, F. Cerrina und M. Onellion, "Dense arrays of nanopores as x-ray lithography masks", Appl. Phys. Let., Bd. 84, Nr. 17, 26. April 2004]. Struktur und Tiefe der Nanoporen sind außerdem durch plasma- oder nasschemische Ätzverfahren weiter modifizierbar. Derartige Porenfelder können als Form für die Herstellung und räumliche Anordnung von Nanodrähten, -stäben oder -röhren dienen [R. B. Wehrspohn, "Geordnete poröse Nanostrukturen - ein Baukastensystem für die Photonik", Habilitationsschrift, Universität Halle-Wittenberg, 2003].

Nanoporöse Filtersysteme sind eine viel versprechende Methode zur Minimierung der Emission von Nanometerpartikeln, des sogenannten Feinstaubs, der in Kraftfahrzeugmotoren entsteht und der im Wesentlichen für die negativen gesundheitlichen Auswirkungen von Luftverschmutzung verantwortlich gemacht wird. Die Filterwirkung beruht dabei auf der mechanischen Absperrung für Partikel oberhalb einer bestimmten Größe und/oder der katalytischen Umwandlung derselben oder giftiger Schadstoffe an den Innenseiten der Poren [H. Presting, U. König, "Future nanotechnology developments for automotive applications", Mat. Science and Eng. C., 23, 737-741, 2003].

Die technischen Herstellungsstrategien für solche großflächigen Mikro- und Nanoporen-Massenanordnungen waren bisher auf optische Lithographieverfahren und *Imprint*-Lithographieverfahren beschränkt. Diese bekannten Prozesse sind mit einem hohen technischen Aufwand verbunden und demzufolge sehr kosten- und zeitintensiv.

Die Druckschriften US 2003/150791 A1, EP 0 083 510 A2, US-A-5-871 870, US 2002/179565 A1 und WO 2004/010229 A offenbaren jeweils Verfahren zur Herstellung von Mikro- und Nanoporen-Massenanordnungen, wie z.B. für Lithographiemasken, auf einem Substrat. Zur Erreichung einer gleichmäßigen Verteilung von Partikeln auf der Substratoberfläche und Vermeidung von Clusterbildung beim Trocknen der Substratoberfläche offenbart EP 0 083 510 A2 die optimierte Einstellung einer Rotationsgeschwindigkeit während der Trocknung der verwendeten kolloidalen Dispersion, US-A-5-871 870 lehrt die Verwendung einer Mischung von Maskenpartikeln mit sublimierbaren Abstandspartikeln und US 2002/179565 A1 offenbart die Verwendung von Partikeln, die mit einem sublimierbaren Stoff wie Naphthalin beschichtet sind.

Die Aufgabe der vorliegenden Erfindung besteht daher in der Bereitstellung eines neuen verbesserten Verfahrens, mit dem sich solche Strukturen, insbesondere für alle obengenannten Anwendungen, einfacher und kostengünstiger herstellen lassen.

Diese Aufgabe wird erfindungsgemäß durch das Verfahren nach Anspruch 1 gelöst. Bevorzugte Ausführungsformen der Erfindung sind Gegenstand der abhängigen Ansprüche 2-12.

Das erfindungsgemäße Verfahren beruht auf der Verwendung selbstorganisierender kolloidaler Nano- und Mikropartikel zur Erzeugung von großflächigen (> cm²) Porenfeldern auf einer Vielfalt von Substraten, z.B. Metallen, Metalloxiden, Kristallen wie z.B. CaF₂, Glas, Silicium und Kunststoffoberflächen, z.B. thermoplastischen, elastischen, strukturvernetzten oder vernetzten Polymeren, in kontrollierten Mustern. Der Begriff "Kolloide", wie hier verwendet, bedeutet stoffklassenübergreifend Partikel einer typischen Längenskala von 10 - 10⁴ nm. Von Natur und Technik wird die Selbstorganisation dieser Teilchen genutzt, um strukturierte Materialien zu erzeugen, die interessante optische, mechanische, oder chemische Eigenschaften haben [S. Eiden, "Kolloide: Alte Materialien, neue Anwendungen", Nachrichten aus der Chemie, 52, 1035-1038, Oktober 2004].

Das erfindungsgemäße Verfahren zur Herstellung von Mikro- und/oder Nanoporen-Massenanordnungen auf einem Substrat umfasst
a) Funktionalisierung der Substratoberfläche in ausgewählten Bereichen;
b) Abscheidung von kolloidalen Partikeln, die das Vermögen zur selektiven Bindung an die funktionalisierten Bereiche der Substratoberfläche besitzen, aus einer wässrigen Dispersion auf der Substratoberfläche, wobei sich eine geordnete Monoschicht der Partikel auf der Substratoberfläche ausbildet;
c) Abtrennung von nicht-gebundenen kolloidalen Partikeln;
d) Einfrieren des Substrats; und
e) Sublimation des Residualwassers auf dem Substrat im Vakuum, wobei die Nahordnung der Partikelmonoschicht erhalten bleibt.

In einer spezielleren Ausführungsform umfasst das Verfahren ferner
f) Aufbringen einer Metallschicht auf der getrockneten Substratoberfläche;
g) anschließende Entfernung der Partikel von der Substratoberfläche, wobei eine poröse Metallschicht zurückbleibt.

In einer noch spezielleren Ausführungsform umfasst das Verfahren ferner
h) Feineinstellung von Porengröße und Porenabstand durch eine Nachhandlung der Substratoberfläche, z.B. mittels Plasmaätzen, stromlose Metallisierung oder Galvanisierung.

Die Funktionalisierung der Substratoberfläche geschieht durch Aufbringung eines Haftvermittlers. Substrate können eine Vielzahl von Materialien, z.B. Glas/Quarzglas, Silicium, Siliciumnitrit, Metalle, Metalloxide, Kristalle wie z.B. CaF₂, und Kunststoffe, sein. Als Haftvermittler kommen grundsätzlich alle im Stand der Technik bekannten Haftvermittler in Betracht. In einer Ausführungsform der Erfindung wird der Haftvermittler physikalisch, z.B. durch Adsorption, an die Substratoberfläche gebunden. Einige, nicht-beschränkende Beispiele hierfür sind organische Polymere, z.B. Polyethylenimin (PEI) und Verbindungen mit ionischen bzw. ionisierbaren funktionellen Gruppen, z.B. Polyamidharze. Auch Polymere wie PEG, Polypropylenglycol, Polyvinylpyrrolidon oder Polyvinylakohole sind, vorzugsweise in Kombination mit einer Plasmabehandlung (Y.-S. Lin, H.K. Yasuda, Journal of Applied Polymer Science, Bd. 67, 855-863 (1998)), einsetzbar. Ein weitere geeignete Substanzklasse sind Proteine, z.B. Rinderserumalbumin (BSA).

In einer alternativen Ausführungsform wird der Haftvermittler chemisch an die Substratoberfläche gebunden. Spezielle Beispiele für derartige Haftvermittler sind funktionelle Organosilane oder Silan-Derivate, z.B. der allgemeinen Formel (X)₃SiR'Y, wobei X = Halogen, OR, NR₂; Y = Amin, Methacrylat, Epoxid, Thiol, Carboxyl. Eine weitere Methode zur Anbindung spezifischer, insbesondere ionischer, funktioneller Gruppen auf organischen Substratoberflächen ist die Beschichtung mit Photoinitiatoren, die durch UV-Licht aktiviert werden. Beispiele für solche Initiatoren sind funktionalisierte Acrylat- und Methacrylatverbindungen (M. Kunz, M. Bauer, Vakuum in Forschung u. Praxis (2001), Nr. 2, 115-120; WO 00/24527).

Ebenfalls einsetzbar sind anorganische Haftvermittler, z.B. Phosphat-, Chromat- und Titanatschichten.

Es können auch mehrere Haftvermittler, sowohl physikalisch als auch chemisch gebundene, gleichzeitig eingesetzt werden.

Die in dem Verfahren der vorliegenden Erfindung verwendeten kolloidalen Partikel besitzen typischerweise eine positive oder negative Oberflächenladung und die Funktionalisierung der Substratoberfläche erzeugt in den ausgewählten Bereichen eine dazu entgegengesetzte Oberflächenladung und veranlasst die Bindung der Partikel durch elektrostatische Wechselwirkung.

Als kolloidale Partikel zur Verwendung in der vorliegenden Erfindung sind grundsätzlich alle kolloidalen Partikel geeignet, die an die funktionalisierte Substratoberfläche binden können. Vorzugsweise geschieht diese Bindung durch elektrostatische Wechselwirkung. Spezieller sind die kolloidalen Partikel aus unsubstituierten oder substituierten organischen Polymeren, z.B. Polystyrol (PS), Poly(methyl)methacrylat (PMMA), Polyvinyltoluol (PVT), Styrol/Butadien-Copolymer (SB), Styrol/Vinyltoluol-Copolymer (S/VT), Styrol/Divinylbenzol (S/DVB), oder anorganischen Partikeln, z.B. Siliciumdioxid, Titandioxid, Zirconiumdioxid, ausgewählt. Vorzugsweise sind die organischen Polymere mit Amino-, Carboxy- oder Sulfatgruppen substituiert. Derartige Kolloide sind mit hoher Monodispersität im Handel erhältlich.

Die erfindungsgemäß verwendeten kolloidalen Partikel weisen typischerweise eine mittlere Größe in einem Bereich von 10 nm - 10 µm, vorzugsweise 50 nm - 5 µm, bevorzugter 100 nm - 2 µm, auf.

Die Partikellage wird durch Eintauchen des Substrats in eine Dispersion aus Kolloiden in einem wässrigen Lösungsmittel, z.B. Wasser oder eine Mischung von Wasser und einem mit Wasser mischbaren organischen Lösungsmittel, z.B. einem Alkohol wie Methanol, Ethanol, Propanol, hergestellt. Ein geeignetes Lösungsmittel kann der Fachmann in Abhängigkeit von den verwendeten Reaktionspartnern und den erforderlichen Verfahrens-bedingungen unschwer bestimmen. In der Regel ist das bevorzugte Lösungsmittel Wasser. Größe und Struktur können dabei durch Funktionalisierung diskreter Bereiche mit einem geeigneten Haftvermittler gezielt gesteuert und kontrolliert werden.

Nach der Beschichtung wird das Substrat in der Regel mit Wasser gespült, um überschüssige, nicht anhaftende Kolloide zu entfernen, und anschließend im feuchten Zustand mit z.B. flüssigem Stickstoff eingefroren. Bei einer hohen Teilchendichte oder zunehmender Partikelgröße führen auftretende Kapillarkräfte beim normalen Trocknen der Monolage zu einer ungewollten Aggregatbildung in kleine Partikelcluster und zu einer Zerstörung der Nahordnung. Dies bedeutet, dass die wie oben erzeugte Partikellage nicht ohne eine Weiterbehandlung als Maske zur Abscheidung einer Deckschicht zur Erzeugung von Nanoporenfelder verwendet werden kann. Herkömmlicherweise wurden für eine solche Weiterbehandlung von Monoschichten beispielsweise relativ aufwändige selektive Plasmaprozesse eingesetzt. In dem Verfahren der vorliegenden Erfindung wird dagegen zum Trocknen eine Sublimationstechnik angewandt, um das Auftreten von Kapillarwechselwirkungen zu vermeiden. Das Residualwasser zwischen den Kolloiden wird durch Gefriertrocknung im Vakuum entfernt und so ein Zusammenlagern der Teilchen verhindert. Die durch Selbstorganisation und gegenseitige Abstoßung der Partikel gebildete Struktur bleibt erhalten. Ein entscheidender Vorteil der Sublimationsmethode besteht somit darin, das die Partikellage direkt zur Erzeugung von Nanoporenfeldern verwendet werden kann.

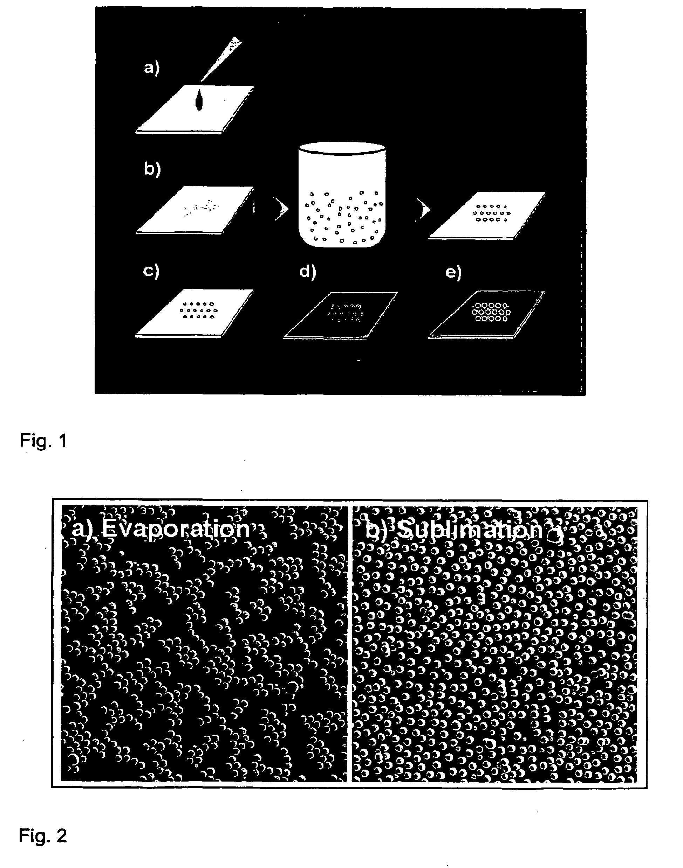

Die mit dem erfindungsgemäßen Verfahren hergestellte Nano- und Mikroporen-Massenanordnung kann als lithographische Maske zum Aufbringen einer Metallschicht auf ein funktionelles Trägermaterial verwendet werden (Fig. 1). Als Substrat kommen eine Vielzahl von Materialien wie beispielsweise Glas/Quarzglas, Silicium, Siliciumnitrit, Kunststoffe oder die anderen bereits oben genannten Substrate in Betracht.

Die Partikellage wird durch Eintauchen des Substrats in eine Dispersion aus Kolloiden in einem wässrigen Lösungsmittel, z. B. Wasser oder eine Mischung von Wasser und einem organischen Lösungsmittel, vorzugsweise Wasser, hergestellt. Größe und Struktur können dabei durch Funktionalisierung diskreter Bereiche mit einem geeigneten Haftvermittler gezielt gesteuert und kontrolliert werden. Die Adhäsion der geladenen Kügelchen an der Oberfläche erfolgt vorzugsweise aufgrund elektrostatischer Wechselwirkungen.

Nach der Dekoration wird das Substrat zunächst mit Wasser gespült und anschließend die feuchte Probe mit z.B. flüssigem Stickstoff eingefroren. Bei einer hohen Teilchendichte oder zunehmender Partikelgröße führen auftretende Kapillarkräfte beim Trocknen der Monolage zu einer ungewollten Aggregatbildung in kleine Partikelcluster. Um dies zu verhindern, wird das Residualwasser zwischen den Kolloiden im Vakuum absublimiert, so dass die Struktur der Nahordnung zwischen den Partikeln, die aus der gegenseitigen elektrostatischen Abstoßung resultiert erhalten bleibt (Fig.2).

Nach dem Bedampfen der Oberfläche mit einem Metall werden abschließend die Partikel nasschemisch oder im Ultraschallbad entfernt. Auf dem Substrat verbleibt ein poröser Überzug, der wiederum als Ätzmaske zur weiteren Verarbeitung verwendet werden kann. Die Beschaffenheit der Poren hinsichtlich Größe und lateralem Abstand sowie der Bedeckungsgrad sind durch entsprechend gewählte Prozessparameter wie der Salzkonzentration und dem pH-Wert der Kolloiddispersion sowie der Stärke der Oberflächenladung der Partikel und des Substrats einstellbar. Der Porendurchmesser und die Porenabstände lassen sich bei diesem Verfahren zusätzlich durch isotropes Plasmaätzen der Partikelmaske vor der Metallbeschichtung oder durch stromlose Metallisierung oder Galvanisierung der Porenmaske aus einer Metallsalzlösung nach dem Partikel-Lift-Off kontrollieren. Das Ätzverfahren eignet sich insbesondere für Oberflächen, die der Materialbelastung durch einen Plasmaprozess standhalten, während sich für empfindlichere Materialien die zweite Methode anbietet.

### Kurzbeschreibung der Figuren

**Fig. 1** ist eine schematische Darstellung des in Bespiel 1 beschriebenen Verfahrens zur Herstellung einer Poren-Massenordnung auf einem Substrat.
**Fig. 2** zeigt die Ergebnisse zweier Verfahren zur Trocknung abgeschiedener Partikelschichten im Vergleich
   a) herkömmliche Trocknung
   b) Sublimation.
**Fig. 3** zeigt die Abhängigkeit der Porengröße vom Partikeldurchmesser.
**Fig. 4** zeigt die Veränderung des Partikeldurchmessers durch eine Ätzbehandlung der Partikel.

Die folgenden Beispiele dienen zur näheren Erläuterung der vorliegenden Erfindung, ohne diese jedoch darauf zu beschränken.

### BEISPIEL 1

### Herstellung einer Poren-Massenanordnung auf einem Glassubstrat

Eine 10 gew.-%ige Lösung von Rinderserumalbumin (BSA) in Wasser wird auf ein gereinigtes Deckgläschen aufgebracht. Nach zehn Minuten Einwirkzeit ist eine ca. 6 nm dicke Lage BSA auf der Oberfläche adsorbiert. Das Substrat wird in einem Becherglas mit Milli-Q-Wasser gespült und mit Stickstoff trocken geblasen (Fig. 1a).

Das funktionalisierte Glasplättchen wird in eine 2,5 gew. -%ige Dispersion von Polystyrol-Partikeln in Wasser getaucht (Fig. 1b). Aufgrund elektrostatischer Wechselwirkungen zwischen dem BSA-Film und den Sulfatgruppen auf der Partikeloberfläche erfolgt die Adsorption nur an den mit Haftvermittler präparierten Bereichen des Substrats. Die dekorierte Oberfläche wird mit Wasser gespült, um überschüssige, nicht anhaftende Partikel zu entfernen, und die noch nasse Probe in flüssigen Stickstoff getaucht. Die in der Flüssigkeit aufgrund der gegenseitigen, elektrostatischen Abstoßung entstandene Partikelnahordnung bleibt durch das plötzliche Vereisen erhalten.

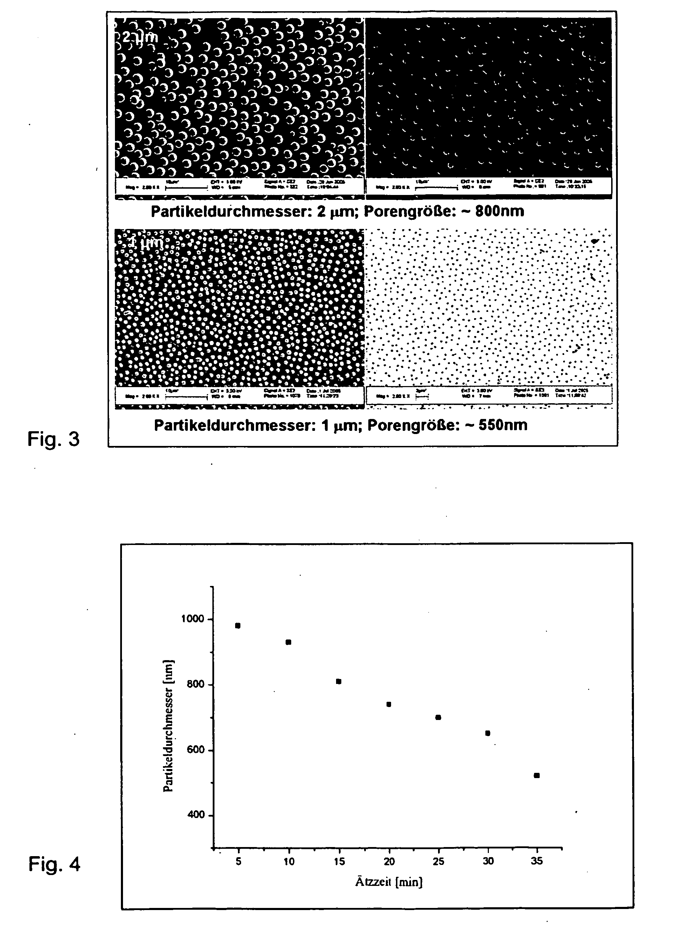

Der gefrorene Rückstand von Dispergens wird in einer Schlenck-Apparatur bei einem Druck von 10⁻¹ - 10⁻² mbar bei Raumtemperatur absublimiert. Auf die getrockneten Partikel wird in einem Sputterprozess eine Metallschicht gewünschter Dicke aufgedampft. Abschließend werden die Kügelchen während ca. 10 min im Ultraschallbad vollständig von der Trägeroberfläche gelöst. Als Ergebnis erhält man eine poröse Metalloberfläche auf dem Ausgangssubstrat mit einem Porendurchmesser, abhängig von der Größe, und einem Porenabstand, abhängig von Oberflächenladung der eingesetzten Partikel (Fig. 3).

Durch selektives isotropes Kleinätzen der Kügelchen in einem chemischen Plasmaprozess vor dem Aufbringen der Metallschicht kann man zusätzlich den Porendurchmesser und Porenabstand variieren (Fig. 4). Alternativ ist es auch möglich, die metallische Porenmaske durch stromlose oder elektrochemische Abscheidung aus einer entsprechenden Metallsalzlösung zu verändern und damit die Porenparameter zu kontrollieren.

### BEISPIEL 2

### Substratfunktionalisierung mit Organosilanen

Die Funktionalisierung der Substratoberfläche erfolgt durch kovalente Anbindung von 3-Aminopropyltriethoxysilan *[NH₂ (CH₂) Si (OC₂H₅) ₃]*.

Glassubstrate werden zunächst 30 Minuten in Carot`scher Säure (H₂O₂/H₂SO₄ im Verhältnis 1:3) gereinigt und anschließend mit Milli-Q-Wasser und Methanol im Ultraschallbad gespült. Die Silanisierung der Oberfläche erfolgt durch Eintauchen des Substrats in eine Lösung aus 290 ml Methanol, 3 ml Aminosilan, 5 ml H₂O und 18 µl Eisessig bei einer Reaktionszeit von 12 Stunden. Abschließend wird das Glasplättchen mehrfach mit Methanol gespült und trocken geblasen. [D. Cuvelier, O. Rossier, P. Bassereau, P. Nassoy, Eur. Biophys. J., 2003, 32, 342-354].

Die Anbindung von Monolagen unterschiedlicher Organosilan- Derivate konnte bereits an Substraten wie beispielsweise Silizium, Aluminiumoxid, Quarz, Glas, Mica, Zinkselenid, Germaniumoxid und Gold gezeigt werden. [A. Ulman, Chem. Rev., 1996, 96, 1533-1554]

Das funktionalisierte Substrat wird in eine wässrige Dispersion kolloidaler Polystyrol-Partikel getaucht. Die weitere Behandlung erfolgt analog der in Beispiel 1 beschriebenen Vorgehensweise.

### BEISPIEL 3

### Funktionalisierung von Silizumoxidpartikeln mit Organosilanen

Anorganische Siliziumoxid-Partikel werden mit Triethoxysilylpropyl-succinylanhydrid (TESPSA) funktionalisiert. Die Silanisierung gelingt durch Inkubation der Partikel in einer 10 %-igen Lösung TESPSA in Toluol über 16 Stunden [G.K. Toworfe, R.J. Composto, I.M. Shapiro, P. Ducheyne, Biomaterials, 2006, 27(4), 631-642]. Die Partikel werden durch Abzentrifugieren und Ultraschallbehandlung in mehreren Reinigungsschritten von der Reaktionslösung getrennt und mit Toluol und Wasser gespült. Abschließend werden die carboxylierten Partikel in Milli-Q-Wasser resuspendiert.

Eine 0.1 %ige Lösung Polyethylenimin (PEI) in Wasser wird auf eine gereinigte Glasoberfläche aufgebracht. Nach zehn Minuten Einwirkzeit ist ein dünner Film PEI auf der Oberfläche adsorbiert. Das Substrat wird in einem Becherglas mit Milli-Q-Wasser gespült und getrocknet. Die Partikeldekoration erfolgt aufgrund attraktiver Wechselwirkungen zwischen den Aminogruppen auf der Substratoberfläche und den Carboxylgruppen der SiO₂-Partikel.

Die weitere Behandlung erfolgt analog der in Beispiel 1 beschriebenen Vorgehensweise.

## Patentansprüche

1. Verfahren zur Herstellung von Mikro- und/oder Nanoporen-Massenanordnungen auf einem Substrat, umfassend
a) Funktionalisierung der Substratoberfläche in ausgewählten Bereichen durch Aufbringung eines Haftvermittlers;
b) Abscheidung von kolloidalen Partikeln, die das Vermögen zur selektiven Bindung an die funktionalisierten Bereiche der Substratoberfläche besitzen, aus einer wässrigen Dispersion auf der Substratoberfläche, wobei sich eine geordnete Monoschicht der Partikel auf der Substratoberfläche ausbildet;
c) Abtrennung von nicht-gebundenen kolloidalen Partikeln;
d) Einfrieren des Substrats; und
e) Sublimation des Residualwassers auf dem Substrat im Vakuum, wobei die Nahordnung der Partikelmonoschicht erhalten bleibt.

2. Verfahren nach Anspruch 1, umfassend ferner
f) Aufbringen einer Metallschicht auf der getrockneten Substratoberfläche;
g) anschließende Entfernung der Partikel von der Substratoberfläche, wobei eine poröse Metallschicht zurückbleibt.

3. Verfahren nach Anspruch 2, umfassend ferner
h) Feineinstellung von Porengröße und Porenabstand durch eine Nachhandlung der Substratoberfläche, z.B. mittels Plasmaätzen, stromlose Metallisierung oder Galvanisierung.

4. Verfahren nach einem der Ansprüche 1-3, **dadurch gekennzeichnet, dass** der Haftvermittler physikalisch, z.B. durch Adsorption, an die Substratoberfläche gebunden wird.

5. Verfahren nach Anspruch 4, **dadurch gekennzeichnet, dass** als Haftvermittler ein organisches Polymer, z.B. Polyethylenimin (PEI) oder ein Polyamidharz, oder ein Protein, z.B. Rinderserumalbumin (BSA), an die Substratoberfläche gebunden wird.

6. Verfahren nach einem der Ansprüche 1-3, **dadurch gekennzeichnet, dass** der Haftvermittler chemisch an die Substratoberfläche gebunden wird.

7. Verfahren nach Anspruch 6, **dadurch gekennzeichnet, dass** als Haftvermittler mindestens ein Organosilan oder Silanderivat der allgemeinen Formel (X)₃SiR'Y, wobei X = Halogen, OR, NR₂; Y = Amin, Methacrylat, Epoxid, Thiol, Carboxyl, an die Substratoberfläche gebunden wird.

8. Verfahren nach einem der Ansprüche 1-7, **dadurch gekennzeichnet, dass** die kolloidalen Partikel eine positive oder negative Oberflächenladung besitzen und die Funktionalisierung der Substratoberfläche in den ausgewählten Bereichen eine dazu entgegengesetzte Oberflächenladung erzeugt und die Bindung der Partikel durch elektrostatische Wechselwirkung geschieht.

9. Verfahren nach einem der Ansprüche 1-8, **dadurch gekennzeichnet, dass** die kolloidalen Partikel eine mittlere Größe in einem Bereich von 10 nm - 10 µm, vorzugsweise 50 nm - 5 µm, bevorzugter 100 nm - 2 µm, aufweisen.

10. Verfahren nach einem der Ansprüche 1-9, **dadurch gekennzeichnet, dass** die kolloidalen Partikel aus unsubstituierten oder substituierten organischen Polymeren, z.B. Polystyrol (PS), Poly(methyl)methacrylat (PMMA), Polyvinyltoluol (PVT), Styrol/Butadien-Copolymer (SB), Styrol/Vinyltoluol-Copolymer (S/VT), Styrol/Divinylbenzol (S/DVB) oder anorganischen Partikeln, z.B. Siliciumdioxid, Titandioxid, Zirconiumdioxid, ausgewählt sind.

11. Verfahren nach Anspruch 10, **dadurch gekennzeichnet, dass** die organischen Polymere mit Amino-, Carboxy- oder Sulfatgruppen substituiert sind.

12. Verfahren nach einem der Ansprüche 2-11, **dadurch gekennzeichnet, dass** die Entfernung der Partikel in Schritt g) durch eine nasschemische Behandlung oder in einem Ultraschallbad geschieht.

## Claims

1. A process for the production of micro- and/or nanopore mass arrangements on a substrate, comprising
a) functionalization of the substrate surface in selected areas by the application of an adhesion promoter;
b) deposition of colloidal particles that have the capacity to selectively bond to the functionalized areas of the substrate surface from an aqueous dispersion on the substrate surface, during which an ordered monolayer of the particles forms on the substrate surface;
c) separation of non-bound colloidal particles;
d) freezing of the substrate; and
e) sublimation of the residual water on the substrate in the vacuum, during which the near range order of the particle monolayer is preserved.

2. The process according to Claim 1, furthermore comprising
f) application of a metallic coating on the dried substrate surface;
g) subsequent removal of the particles from the substrate surface, while a porous metallic layer remains.

3. The process according to Claim 2, furthermore comprising
h) fine adjustment of pore size and pore distance by a posttreatment of the substrate surface, e.g., by plasma etching, currentless metallization or galvanization.

4. The process according to one of Claims 1 to 3, **characterized in that** the adhesion promoter is bound physically, e.g., by adsorption, to the substrate surface.

5. The process according to Claim 4, **characterized in that** an organic polymer, e.g., polyethylene imine (PEI) or a polyamide resin, or a protein, e.g., bovine serum albumin (BSA), is bound to the substrate surface as adhesion promoter.

6. The process according to one of Claims 1 to 3, **characterized in that** the adhesion promoter is chemically bound to the substrate surface.

7. The process according to Claim 6, **characterized in that** at least one organosilane or silane derivative of the general formula (X)₃SiR'Y, in which X = halogen, OR, NR₂; Y = amine, methacrylate, epoxide, thiol, carboxyl, is bound to the substrate surface as adhesion promoter.

8. The process according to one of Claims 1 to 7, **characterized in that** the colloidal particles have a positive or negative surface charge and the functionalization of the substrate surface produces a surface charge opposite to it in the selected areas and that the bonding of the particles takes place by electrostatic interaction.

9. The process according to one of Claims 1 to 8, **characterized in that** the colloidal particles have a mean size in a range of 10 nm - 10 µm, preferably 50 nm - 5 µm, more preferably 100 nm - 2 µm.

10. The process according to one of Claims 1 to 9, **characterized in that** the colloidal particles are selected from non-substituted or substituted organic polymers, e.g., polystyrene (PS), poly(methyl)methacrylate (PMMA), polyvinyltoluene (PVT), styrene/butadiene-copolymer (SB), styrene/vinyltoluene copolymer (S/VT), styrene/divinylbenzene (S/DVB), or inorganic particles, e.g., silicon dioxide, titanium dioxide, zirconium dioxide.

11. The process according to Claim 10, **characterized in that** the organic polymers are substituted with amino-, carboxy- or sulfate groups.

12. The process according to one of Claims 2 to 11, **characterized in that** the removal of the particles in step g) takes place by a wet-chemical treatment or in an ultrasonic bath.

## Revendications

1. Procédé de fabrication d'ensembles de masses à micro- et/ou nanopores sur un substrat, comprenant :
a) la fonctionnalisation de la surface du substrat dans des zones choisies par dépôt d'un agent d'adhérence ;
b) le dépôt de particules colloïdales possédant la capacité de liaison sélective aux zones fonctionnalisées de la surface du substrat, à partir d'une dispersion aqueuse sur la surface du substrat, une monocouche ordonnée de particules se formant sur la surface du substrat ;
c) la séparation des particules colloïdales qui ne se sont pas liées ;
d) la congélation du substrat ; et
e) la sublimation de l'eau résiduelle se trouvant sur le substrat sous vide, l'ordre à courte distance de la monocouche de particules étant conservé.

2. Procédé selon la revendication 1, comprenant en outre :
f) le dépôt d'une couche métallique sur la surface du substrat séchée ;
g) l'élimination consécutive des particules de la surface du substrat, une couche métallique poreuse subsistant.

3. Procédé selon la revendication 2, comprenant en outre :
h) le réglage fin de la taille des pores et de la distance entre les pores par une manipulation ultérieure de la surface du substrat, par exemple au moyen de la gravure plasma, de la métallisation ou de la galvanisation non électrolytique.

4. Procédé selon l'une des revendications 1 à 3, **caractérisé en ce que** l'agent d'adhérence est lié physiquement, par exemple par adsorption, à la surface du substrat.

5. Procédé selon la revendication 4, **caractérisé en ce qu'**un polymère organique, par exemple la polyéthylène-imine (PEI) ou une résine polyamide, ou une protéine, par exemple l'albumine de sérum de bovin (BSA), est lié à la surface du substrat à titre d'agent d'adhérence.

6. Procédé selon l'une des revendications 1 à 3, **caractérisé en ce que** l'agent d'adhérence est lié chimiquement à la surface du substrat.

7. Procédé selon la revendication 6, **caractérisé en ce qu'**au moins un organosilane ou un dérivé de silane de formule générale (X)₃SiR'Y, où X = halogène, OR, NR₂ ; Y = amine, méthacrylate, époxyde, thiol, carboxyle, est lié à la surface du substrat à titre d'agent d'adhérence.

8. Procédé selon l'une des revendications 1 à 7, **caractérisé en ce que** les particules colloïdales possèdent une charge de surface positive ou négative et la fonctionnalisation de la surface du substrat dans les zones choisies produit une charge de surface opposée à la précédente et la liaison des particules se fait par interaction électrostatique.

9. Procédé selon l'une des revendications 1 à 8, **caractérisé en ce que** les particules colloïdales présentent une taille moyenne située dans une plage allant de 10 nm à 10 µm, de préférence de 50 nm à 5 µm, plus préférentiellement de 100 nm à 2 µm.

10. Procédé selon l'une des revendications 1 à 9, **caractérisé en ce que** les particules colloïdales sont choisies parmi les polymères organiques substitués ou non substitués, par exemple le polystyrène (PS), le polyméthacrylate de méthyle (PMMA), le polyvinyltoluène (PVT), le copolymère de styrène/ butadiène (SB), le copolymère de styrène/vinyltoluène (S/VT), le styrène/ divinylbenzène (S/DVB) ou les particules inorganiques, par exemple le dioxyde de silicium, le dioxyde de titane, le dioxyde de zirconium.

11. Procédé selon la revendication 10, **caractérisé en ce que** les polymères organiques sont substitués par des groupes amino, carboxy ou sulfate.

12. Procédé selon l'une des revendications 2 à 11, **caractérisé en ce que** l'élimination des particules s'effectue à l'étape g) par un traitement chimique par voie humide ou dans un bain d'ultrasons.
